# EUROPEAN PATENT SPECIFICATION

(11) **EP 2 393 123 B1**
(45) Date of publication and mention of the grant of the patent: **10.12.2014**
(21) Application number: 10735923.4
(22) Date of filing: 29.01.2010
(51) Int. Cl.: H01L 31/04, H01L 31/048

(54) **SOLAR CELL MODULE AND METHOD FOR MANUFACTURING SAME**
SOLARZELLENMODUL UND VERFAHREN ZU SEINER HERSTELLUNG
MODULE DE CELLULE SOLAIRE ET SON PROCÉDÉ DE FABRICATION

(30) Priority: 29.01.2009 JP 2009018414; 28.08.2009 JP 2009198435
(43) Date of publication of application: 07.12.2011
(73) Proprietor: Kyocera Corporation, Kyoto-shi Kyoto 612-8501 (JP)
(72) Inventor: KYODA Takeshi, Higashiomi-shi Shiga 527-8555 (JP); NIWA Tetsuo, Higashiomi-shi Shiga 527-8555 (JP); TAMAKI Motoi, Osaka-shi Osaka 540-0003 (JP)
(74) Representative: Witte, Weller & Partner Patentanwälte mbB
(86) International application number: PCT/JP2010/051293
(87) International publication number: WO 2010/087461

(56) References cited:
- EP-A1- 1 564 816
- JP-A- 9 108 741
- JP-A- 2001 339 091
- JP-A- 2005 302 902
- JP-A- 2008 282 926
- US-A1- 2007 227 585

## Description

### TECHNICAL FIELD

The present invention relates to a solar cell module and a method of manufacturing the same.

### BACKGROUND ART

In recent years, spreading and expansion of a solar cell module has advanced in view of environmental protection. In general, a solar cell module is obtained by providing, in an order from a light receiving surface side, a translucent substrate, a solar cell element string (a solar cell string) having a periphery protected by a sheet-like filler formed by a transparent thermosetting resin or the like, and a back surface protecting member for protecting a back surface, and integrating them. In particular, a solar cell element containing silicon is often used because of high power generation efficiency. The solar cell string is formed by bonding an electrode provided on one of solar cell elements to an electrode of the other solar cell element which is adjacent to the one solar cell element with a conductor wire that is a wiring member through a solder, thereby connecting them electrically.

In some cases in which the solder is cooled after the bonding, however, a thermal stress is caused by a difference in a coefficient of thermal expansion between the solar cell element and the conductor wire so that a warpage occurs over the solar cell element. Particularly, in the case of a solar cell string in which main surfaces on the same side of the adjacent solar cell elements to each other, for example, non-light receiving surfaces that are back surfaces are bonded to each other through a conductor wire and the conductor wire is not disposed on the light receiving surface side, a warpage causing the light receiving surface side to be convexed as seen on a section taken in a longitudinal direction of the conductor wire is likely to occur in the solar cell element. In the case where the solar cell module is constituted by using the solar cell string including the solar cell element having such a warpage, a stress is applied to the bonding portion of the solar cell element and the conductor wire so that the bonding portion is cracked or broken. As a result, there is a possibility that an output of the solar cell module might be reduced.

Japanese Patent Application Laid-Open No. 2007-250623 proposes a method of locally decreasing a sectional area of a conductor wire, thereby relieving a thermal stress to reduce a warpage. In the case where the conductor wire is provided only on the main surface at the same side in the solar cell element, for example, the back surface, however, the warpage cannot be sufficiently reduced through this method.

US 2007/227585 A1 discloses a photovoltaic module that achieves a reduction in adverse influence of damage accumulated in a collector electrode provided on a light receiving surface. In the photovoltaic module a first region of a sealing material is in contact with the light receiving surface of a solar cell and a second region of the sealing material is in contact with the back surface of the solar cell. The adhesive force of a first region to the solar cell is smaller than that of the second region to the solar cell.

### SUMMARY OF THE INVENTION

The present invention has been made in view of the above problems, and an object thereof is to provide a solar cell module in which a stress of a solar cell string is relieved, and a method of manufacturing the same.

According to the present invention, a solar cell as defined in claim 1 is presented.

According to the solar cell module of the present invention, a stress to be applied to a bonding portion of the solar cell element and the conductor wire is relieved, and it is possible to suitably decrease an occurrence of a crack or breakage in the bonding portion, and furthermore, a reduction in an output of the solar cell module.

Moreover, according to the present invention, a method of manufacturing a solar cell module as defined in claim 10 is presented.

According to the method of manufacturing a solar cell module in accordance with the present invention, the solar cell element planarized in the longitudinal direction of the conductor wire in the second step is used to constitute a solar cell string or a solar cell module. Therefore, a crack can be reduced suitably from occurring in the manufacturing process. Moreover, alignment precision in the solar cell string can be enhanced. In addition, in the solar cell module thus obtained, a stress to be applied to the bonding portion of the solar cell element and the conductor wire is relieved. Therefore, it is possible to suitably decrease an occurrence of a crack or breakage in the bonding portion, and furthermore, a reduction in an output.

### BRIEF DESCRIPTION OF THE DRAWINGS

FIG. 1 is a sectional view showing an example of a solar cell module.
FIG. 2 illustrates perspective views showing an example of a solar cell element having a metal wrap through structure, where (a) is a perspective view showing a first main surface (a light receiving surface side) of the solar cell element, and (b) is a perspective view showing a second main surface (a back surface side) of the solar cell element.
FIG. 3 illustrates views showing an example of a solar cell string, where (a) is a perspective view showing the solar cell string, (b) is a sectional view taken along line X - X in (a), and (c) is a sectional view taken along line Y - Y in (a).
FIG. 4 illustrates views showing a solar cell module constituted by using the solar cell string in FIG. 3, where (a) is a sectional view showing a section taken in a longitudinal direction of a conductor wire, and (b) is a sectional view showing a perpendicular section to the longitudinal direction of the conductor wire.
FIG. 5 is a perspective view showing a solar cell string in which a warpage having a light receiving surface convexed occurs in the solar cell element according to a comparative example.
FIG. 6 is a sectional view showing a solar cell module constituted by using the solar cell string in FIG. 5.
FIG. 7 illustrates views showing a state in which a solar cell element and a conductor wire are bonded to manufacture a solar cell string, where (a) is a perspective view showing a state before the bonding seen from a back surface side (a non-light receiving surface side), and (b) is a perspective view showing a state after the bonding seen from the light receiving surface side.

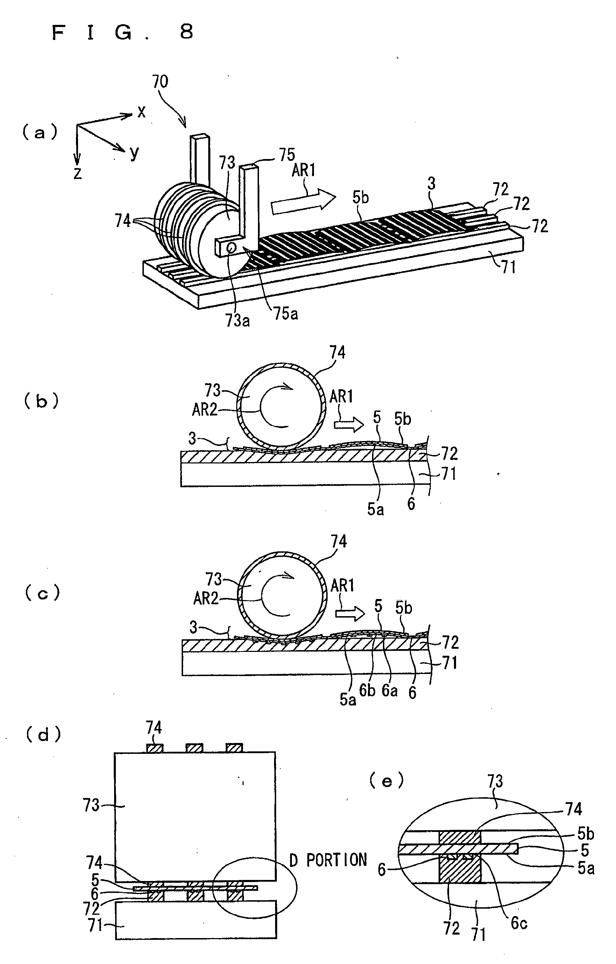

FIG. 8 illustrates views showing a method of manufacturing a solar cell module, where (a) is a perspective view showing a state of processing by a processing apparatus, (b) is a vertical sectional view passing through first and second pressing members and taken in an extending direction of a base, (c) is the same vertical sectional view as (b) in the case where the conductor wire has a concave portion and a convex portion, (d) is a sectional view passing through a portion in which the first and second pressing members abut on the solar cell string and taken in a perpendicular direction to the extending direction of the base, and (e) is an enlarged view showing a D portion of (d).
FIG. 9 is a model view showing a distributed load to be applied to the solar cell string according to the present embodiment.
FIG. 10 is a model view, shown for comparison, showing a state in which the distributed load is applied over a total range in an orthogonal direction to the longitudinal direction of the conductor wire with respect to the solar cell string.

### EMBODIMENT FOR CARRYING OUT THE INVENTION

A solar cell module and a method of manufacturing the same according to the present invention will be described below with reference to the accompanying drawings.

### (Solar Cell Module)

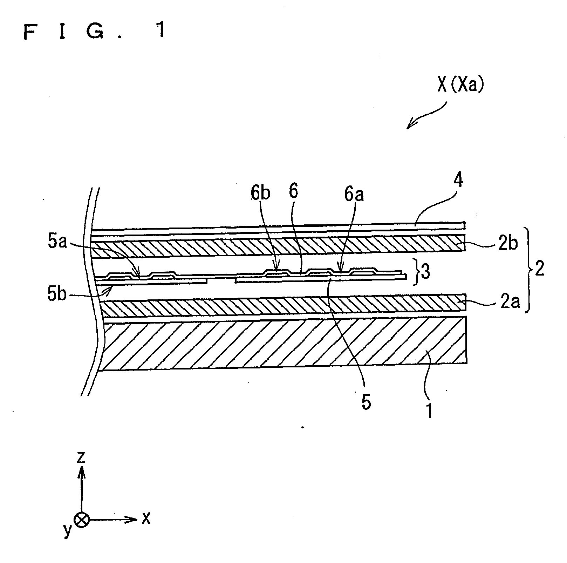

As shown in FIG. 1, a solar cell module X according to the present embodiment is obtained by sequentially laminating a translucent substrate 1, a light receiving surface side filler 2a, a solar cell element string (a solar cell string) 3, a non-light receiving surface side filler 2b, and a back surface protecting member 4. The solar cell string 3 is obtained by electrically connecting a plurality of solar cell elements 5 in series through a conductor wire 6. In the following, the light receiving surface side filler 2a and the back surface side filler 2b are generally referred to as a filler 2. Herein, a surface on a side where light is mainly received is referred to as a light receiving surface and a surface corresponding to a back side of the light receiving surface is referred to as a back surface.

If the translucent substrate 1 is a member capable of causing light to be incident on the solar cell element 5, a material thereof is not particularly restricted. For example, a substrate having a high light transmittance and formed by a glass such as a white plate glass, a strengthened glass, a double strengthened glass or a heat reflecting glass, a polycarbonate resin or the like may be used as the translucent substrate 1. For example, it is preferable that a white plate strengthened glass having a thickness of approximately 3 mm to 5 mm or a synthetic resin substrate (formed by a polycarbonate resin or the like) having a thickness of approximately 5 mm be used as the translucent substrate 1.

The filler 2 serves to seal the solar cell element 5. For example, an organic compound containing, as a principal component, an ethylene vinyl acetate copolymer (EVA) or polyvinyl butyral (PVB) is used as the filler 2. More specifically, the organic compound is formed into a sheet having a thickness of approximately 0.4 to 1 mm by means of a T-die and an extruder, and the sheet is cut in an appropriate size, and a product thus obtained is used as the filler 2. The filler 2 may contain a crosslinking agent. The crosslinking agent serves to couple molecules such as the EVA. An organic peroxide for generating a radical through decomposition at a temperature of 70°C to 180°C can be used as the crosslinking agent, for example. Examples of the organic peroxide include 2,5-dimethyl-2,5-bis(t-butylperoxy)hexane, tert-hexylperoxypivalate, and the like. In the case where the EVA is used for the filler 2, it is preferable that the crosslinking agent be contained in a rate of approximately 1 part by mass with respect to 100 parts by mass of the EVA. In addition to the EVA and the PVB, it is possible to suitably utilize, as the filler 2, a thermosetting resin or a resin obtained by causing the thermoplastic resin to contain the crosslinking agent and to have a thermosetting characteristic. For example, an acryl resin, a silicone resin, an epoxy resin, EEA (an ethylene-ethyl acrylate copolymer) and the like can be utilized as the filler 2.

The back surface protecting member 4 serves to protect the filler 2 and the solar cell element 5. For the back surface protecting member 4, it is possible to use PVF (polyvinyl fluoride), PET (polyethylene terephthalate), PEN (polyethylene naphthalate), or a product obtained by laminating them.

As the solar cell element 5, for example, a back contact type such as a metal wrap through structure or an emitter wrap through structure is suitably used. In the present embodiment, as an example, description will be given to the case where the solar cell element 5 having the metal wrap through structure is used. In the solar cell element 5, moreover, the light receiving surface is indicated as 5b and the back surface is indicated as 5a.

The solar cell element 5 has a structure in which a PN junction of a P layer containing a P-type impurity such as boron in a large quantity and an N layer containing an N-type impurity such as phosphorus in a large quantity is provided in a single crystal silicon substrate or a polycrystalline silicon substrate, and an electrode formed of silver or aluminum (a collecting electrode 51, an output electrode 53, or the like) is disposed on a light receiving surface and/or a back surface of the silicon substrate.

For example, as the single crystal silicon substrate or the polycrystalline silicon substrate, there is used a rectangular shape substrate which is cut out through slicing processing from an ingot, having a thickness of approximately 0.1 mm to 0.3 mm and a size of approximately 150 mm to 160 mm square. Such a silicon substrate can be formed by using a silicon material having a purity of 6 N to 11 N, for example. Moreover, the electrode is formed by using a conductive paste such as a silver paste or an Al paste through a screen printing method or the like.

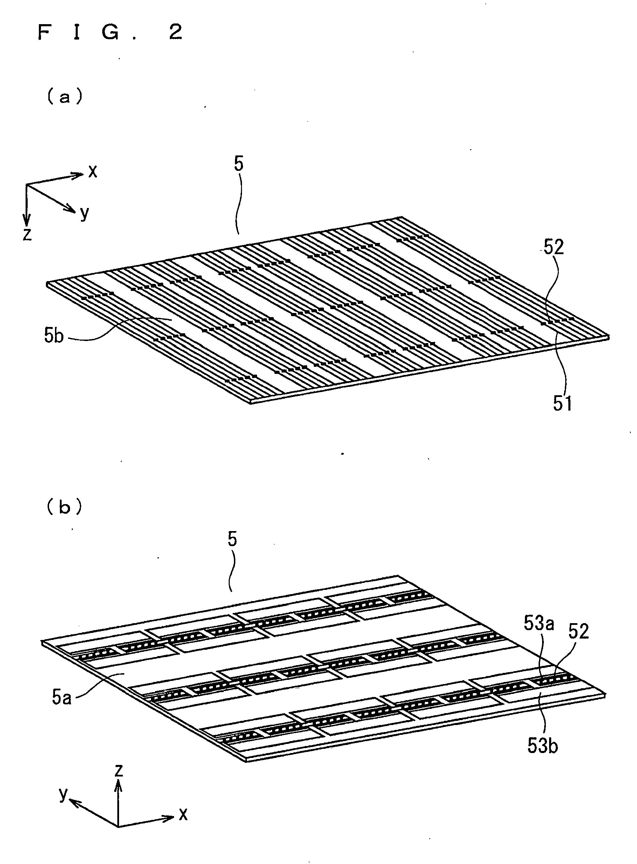

In the case of the solar cell element 5 shown in FIGS. 2(a) and 2(b), the thin collecting electrode 51 referred to as a finger is provided on the light receiving surface 5b, and furthermore, a through hole 52 filled with an electrode material is disposed to guide a carrier generated on the light receiving surface to the back surface 5a. The back surface 5a is provided with positive and negative output electrodes 53 (a positive output electrode 53a and a negative output electrode 53b) for outputting a power. In the solar cell element 5 shown in FIG. 2(b), an array of the positive output electrode 53a and an array of the negative output electrode 53b are alternately provided in parallel with a side of the solar cell element 5, respectively.

In the case where a bus bar electrode is not provided on the light receiving surface as in the solar cell element 5 shown in FIGS. 2(a) and 2(b), an effective light receiving area of the solar cell element 5 is increased so that active area conversion efficiency is increased.

The conductor wire 6 is a member formed by cutting, in an appropriate length, a product obtained by solder coating in a thickness of approximately 20 µm to 70 µm by means of plating or dipping over a surface of a metallic conductor having a low resistance such as copper or aluminum. Since the conductor wire 6 is formed of metal, it has ductility. For the metallic conductor, it is also possible to use a clad copper foil having a structure of copper / invar / copper. In this case, a coefficient of thermal expansion of the conductor wire 6 approximates to that of silicon, whereby the warpage of the solar cell element 5 can be reduced.

The conductor wire 6 is connected to one of the surfaces of the solar cell element and is led out to cross one of the sides which corresponds to an end of the surface. The conductor wire 6 connects output electrodes having different polarities in two adjacent solar cell elements 5 which are adjacent to each other in the solar cell string 3. In other words, the conductor wire 6 is disposed to connect an output electrode 53a of one solar cell element to an output electrode 53b of the other solar cell element. Moreover, as shown in FIG. 2(b), in the case where the positive output electrode 53a and the negative output electrode 53b are provided in a plurality of places in the single solar cell element 5, the conductor wire is connected to each of them.

The conductor wire 6 may have a uniform and long shape with no concavo-convex portion, or, as shown in FIG. 1, may include a concave portion (a bonding portion) 6a having a bottom part connected to the portion disposed on the back surface 5a of the solar cell element 5, and a convex portion (a non-bonding portion) 6b not connected to the back surface 5a. In the latter case, a thermal stress acting on the solar cell string 3 is released in the convex portion 6b, whereby the warpage of the solar cell string 3 can be reduced.

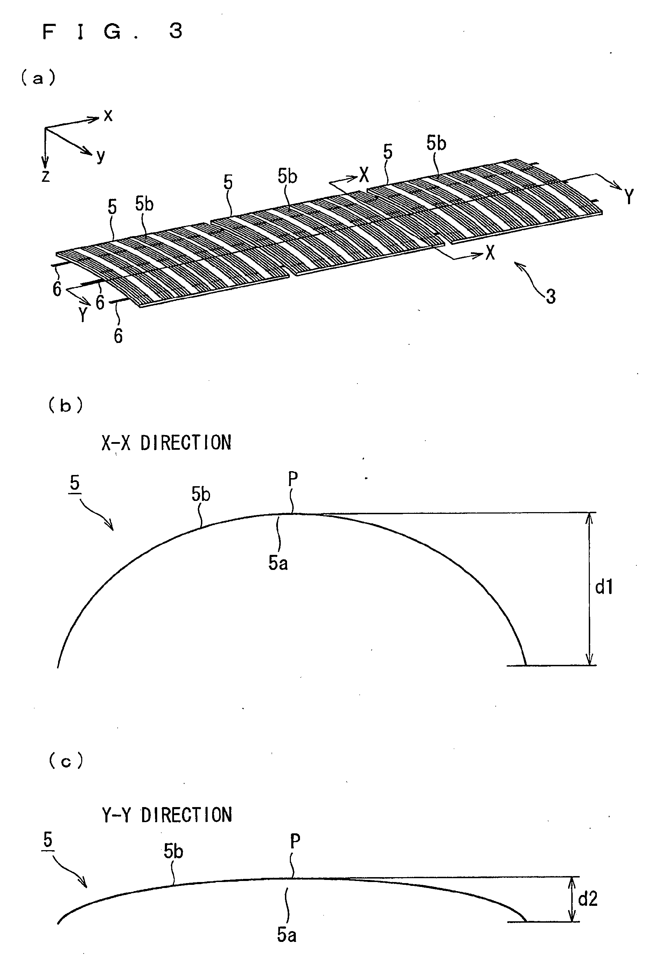

FIG. 1 shows a solar cell module X (which is also referred to as a solar cell module Xa) in which each solar cell element 5 constituting the solar cell string 3 is flat in an array direction thereof, that is, a horizontal direction seen in the drawing which is the longitudinal direction of the conductor wire 6, and the conductor wire 6 is also extended in the same direction along the solar cell element 5. However, it is preferable that the respective solar cell elements 5 of the solar cell string 3 constituting the solar cell module X are flat in the longitudinal direction of the conductor wire 6 but have a convex shape toward the light receiving surface 5b side in a perpendicular section to the longitudinal direction of the conductor wire 6 in a temperature environment of at least an ordinary temperature. The solar cell string 3 shown in FIG. 3(a) corresponds to this. In other words, the solar cell module includes a plurality of solar cell elements, each including a light receiving surface and a back surface positioned on a back side of the light receiving surface, and a conductor wire connecting one of the solar cell elements to any of the solar cell elements which is adjacent thereto and including connecting portions to be connected to one surface of one of the solar cell elements, and the plurality of solar cell elements have a convex shape toward the light receiving surface side in the perpendicular section to the longitudinal direction of the connecting portions is protruded. Although the protruding direction of the solar cell element may be the back surface side, the plurality of solar cell elements are disposed so that the protruding direction of the plurality of solar cell elements correspond to the protruding direction of one of the solar cell elements.

The longitudinal direction of the connecting portion is a direction in which a distance from an end to another end of the connecting surface is the greatest. In other words, in the present specification, the longitudinal direction of the connecting portion represents a crossing direction from an end of the conductor wire in the connecting portion toward a crossing portion.

Furthermore, it is preferable that each of the solar cell elements 5 in the solar cell string 3 have a convex shape toward the light receiving surface 5b side in the perpendicular section to the longitudinal direction of the connecting portion and that a maximum distance (hereinafter referred to as a first maximum distance) in a thickness direction from the back surface 5a toward the light receiving surface 5b in the perpendicular section to the longitudinal direction of the connecting portion is greater than a maximum distance (hereinafter referred to as a second maximum distance) in the thickness direction in the section along the longitudinal direction of the connecting portion. The maximum distance in the thickness direction indicates a perpendicular distance from a lowermost end to an uppermost end as seen in cross-section for each section of the solar cell element 5.

With such a structure, height positions of the connecting portions of the two adjacent solar cell elements are almost equal to each other so that a separation of the connecting portion can be reduced from being caused by a difference in the height position.

More specifically, a maximum distance d1 in a thickness direction is shown in the perpendicular section to the array direction of the solar cell element 5 schematically illustrated in FIG. 3(b). On the other hand, a maximum distance d2 in a thickness direction is shown in a section in the longitudinal direction of the connecting portion of the solar cell element 5 schematically illustrated in FIG. 3(c). In the cases shown in FIGS. 3(b) and 3(c), d1 > d2 is satisfied.

Further, it is preferable that the distance d2 be equal to or smaller than 20 times as much as the thickness of the solar cell element.

Consequently, it is possible to reduce a generation of a stress to be applied to the solar cell element in the solar cell module.

Further, it is preferable that the distance d1 be 21 to 40 times as much as the thickness of the solar cell element.

Consequently, it is possible to reduce the generation of the stress to be applied to the solar cell element in the solar cell module.

Further, it is preferable that a rate d1/d2 of the distance d1 to the distance d2 be 1.5 to 20.

Consequently, it is possible to stabilize a balance of a warpage in X and Y directions while maintaining a relationship of d1 > d2.

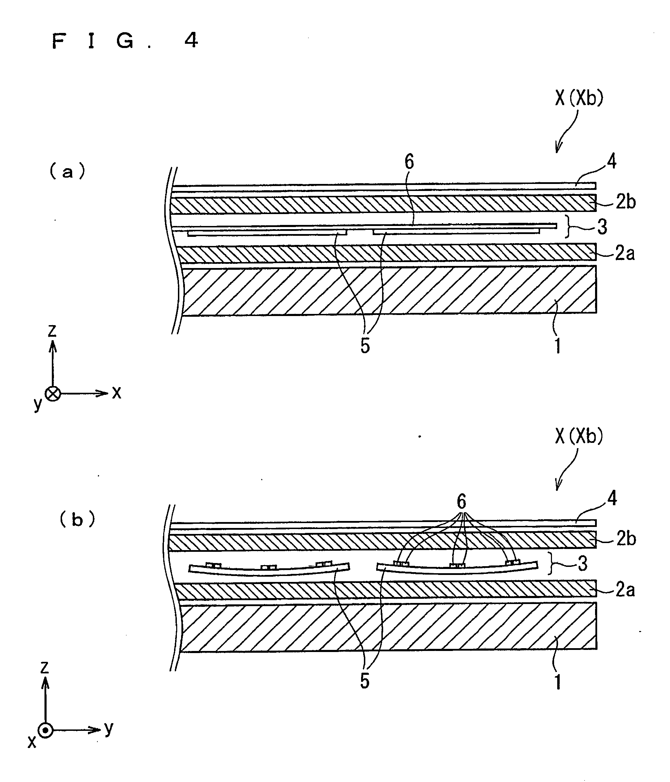

In the case where the solar cell module X (which is referred to as a solar cell module Xb) constituted by using the solar cell string 3 having the shape shown in FIG. 3 is formed, the solar cell element 5 has a flat section in the longitudinal direction of the conductor wire 6 as shown in FIG. 4(a) but a perpendicular section to the longitudinal direction of the conductor wire 6 having a convex shape toward the light receiving surface 5b side as shown in FIG. 4(b).

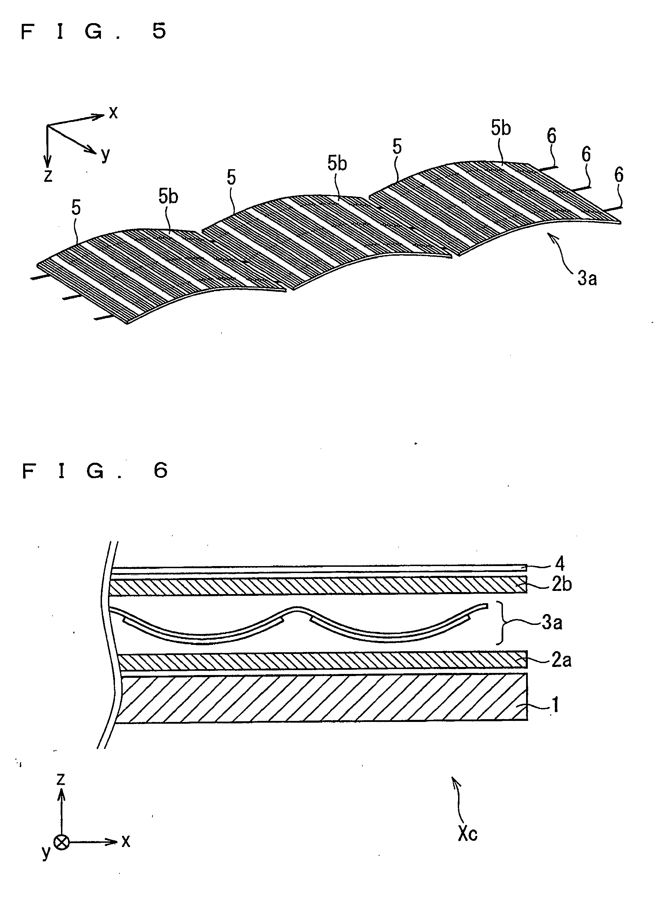

Moreover, for comparison, FIGS. 5 and 6 show a solar cell string 3a in which the light receiving surface 5b side causes a convex warpage in a section in an array direction of each solar cell element 5, and a solar cell module Xc constituted by using the solar cell string 3a. In the solar cell string 3a, each solar cell element 5 is curved uniformly toward the light receiving surface 5b side as seen in the perpendicular direction to the longitudinal direction of the conductor wire 6. A lifting quantity of the solar cell element 5 from a horizontal surface is approximately 5 mm.

By comparing the solar cell string 3a used in the solar cell module Xc with the solar cell string 3 used in the solar cell modules Xa and Xb illustrated in FIGS. 1 and 4, the latter is planarized more greatly when focusing on the section in the longitudinal direction of the conductor wire 6. In the solar cell module Xc, the solar cell element 5 is interposed between the translucent substrate 1, the back surface protecting member 4 and the like so that a force for stretching the solar cell element 5 flatly in the longitudinal direction of the conductor wire 6 is continuously applied. In this case, a stress is applied to the bonding portion of the solar cell element 5 and the conductor wire 6 for a long period of time. Therefore, the solder of the bonding portion is gradually deformed due to a creep phenomenon so that the bonding portion is cracked or broken. As a result, there is a possibility that the output of the solar cell module Xc is reduced. On the other hand, in the case of the solar cell modules Xa and Xb, the solar cell string 3 is planarized in an array direction thereof (the longitudinal direction of the conductor wire 6). Preferably, the solar cell element 5 constituting the solar cell string 3 has a convex shape toward the light receiving surface 5b side and the first maximum distance d1 is greater than the second maximum distance d2. Consequently, it is possible to relieve the stress to be applied to the bonding portion of the solar cell element 5 and the conductor wire 6 and to suitably decrease the occurrence of the crack or breakage in the bonding portion, and furthermore, the reduction in the output of the solar cell module X.

It is more preferable that the solar cell element 5 of the solar cell string 3 constituting the solar cell module X have a convex shape toward the light receiving surface 5b side in the perpendicular section to the longitudinal direction of the conductor wire 6 in a low temperature environment, as described above, but have a convex shape toward the back surface 5a side in a perpendicular section to the array direction in a high temperature environment. In the present embodiment, it is assumed that a low temperature indicates a relatively low temperature range including at least -10°C, a high temperature indicates a relatively high temperature range including at least 80°C, and an ordinary temperature indicates a temperature range between both of them. This can be implemented by causing the solar cell element 5 to include the output electrode 53 formed of A1, for example. In this case, the solar cell string 3 maintains the shape shown in FIG. 3 at a temperature other than the high temperature. Therefore, even if a fluctuation in the temperature occurs within a normal using temperature range of the solar cell module X, it is possible to suitably reduce an occurrence of a stress concentration due to an increase in the warpage of the solar cell element 5.

Note that the invention is not restricted to the embodiment described above, but the case of a protrusion toward a back side is included if an internal stress applied by an electrode or a conductor wire at the back side is higher than that at the light receiving surface side, and a pressing direction in the following manufacturing method is also changed correspondingly as necessary.

### (Method of Manufacturing Solar Cell Module)

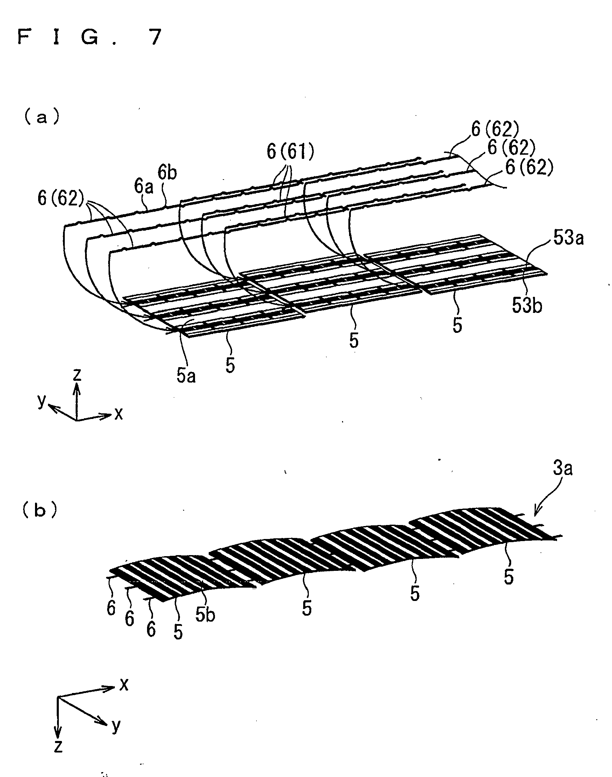

A method of manufacturing the solar cell modules X (Xa, Xb) according to the present embodiment will be described with reference to FIGS. 7 and 8.

First of all, as a first step, the solar cell element 5 and the conductor wire 6 are bonded to each other as shown in FIG. 7(a). The conductor wire 6 is disposed to electrically connect the positive output electrode 53a of each of the solar cell elements 5 to the negative output electrode 53b of the solar cell element 5 which is adjacent thereto in a state where the solar cell elements 5 are arranged. More specifically, the conductor wires 6 different from each other (a first conductor wire 61, a second conductor wire 62) are connected to the respective output electrodes 53 having different polarities respectively in the respective solar cell elements 5. For example, in the case of the center solar cell element 5 of the three solar cell elements 5 shown in FIG. 7(a), the positive output electrode 53a is connected to the negative output electrode 53b of the solar cell element 5 at a right end through the first conductor wire 61 and the negative output electrode 53b is connected to the positive output electrode 53a of the solar cell element 5 at a left end through the second conductor wire 62. The first conductor wire 61 and the second conductor wire 62 are disposed in parallel with each other not to come into contact with each other and not to be short-circuited. It is preferable that at least one of the first conductor wire 61 and the second conductor wire 62 have the concave portion 6a (the bonding portion) and the convex portion 6b (the non-bonding portion) as shown in FIG. 1. In this case, the concave portion 6a is bonded to the output electrode 53 provided on the back surface 5a.

The output electrode 53a or the output electrode 53b and the conductor wire 6 are bonded to each other through a solder. In other words, a heated and molten solder is provided between the output electrode 53a or the output electrode 53b and the conductor wire 6, and this solder is then cooled so that the output electrode 53a or the output electrode 53b and the conductor wire 6 are bonded to each other.

After the bonding, as shown in FIG. 7(b), there may be fabricated the solar cell string 3a in which the solar cell element 5 is curved to be convexed toward the light receiving surface 5b side. The reason for this is that, since the conductor wire 6 that is a metal member has a higher coefficient of thermal expansion than the solar cell element 5 constituted to include the silicon substrate, the conductor wire 6 causes a greater heat shrinkage than the solar cell element 5 when the solder is cooled. Thus, in the case where the solar cell string including the solar cell element 5 having the warpage is exactly subjected to a laminating and integrating step in a subsequent stage, the solar cell module Xc shown in FIG. 6 is fabricated.

Therefore, in the present embodiment, in order to eliminate or reduce the warpage occurring in the array direction in the solar cell element 5 constituting the solar cell string 3 prior to the formation of the solar cell module X, the light receiving surface 5b side of the solar cell string 3 is continuously pressed by means of a rotating member from one end side toward the other end side in the longitudinal direction of the conductor wire 6 to carry out processing for applying a bending stress as a second step.

As shown in FIG. 8(a), a processing apparatus 70 to be used in the second step mainly includes a base 71 for mounting the solar cell string 3 thereon, a first elastic member 72 that is an elastic member provided on the base 71, a pressing roller 73, a second elastic member 74 that is an elastic member provided around the pressing roller 73, and moving means 75 for moving the pressing roller 73.

The base 71 can mount the solar cell string 3 thereon in the longitudinal direction of the conductor wire 6. The solar cell string 3 is mounted in such a manner that the first main surface 5b is turned upward.

The first elastic member 72 is a member which is provided to mainly abut on the conductor wire 6 in a state where the solar cell string 3 is mounted in the manner described above. As shown in FIG. 8(a), in the case where the conductor wire 6 is provided in a plurality of places in the solar cell element 5, the first elastic member 72 is provided corresponding to positions in which the respective conductor wires 6 are disposed.

The pressing roller 73 is a substantially cylindrical member and has a central shaft 73a supported by a bearing portion 75a provided on the moving means 75. The pressing roller 73 is rotated around the central shaft 73a when a rotating force along an outer periphery thereof is applied. In other words, the pressing roller 73 is a rotor. The pressing roller 73 can be moved in a vertical direction (a z-axis direction) and a horizontal direction (an x-axis direction) along the base 71 by means of the moving means 75.

The second elastic member 74 is a member which is provided around the pressing roller 73 to abut on the solar cell string 3 in an upper position of the conductor wire 6 when the pressing roller 73 presses the solar cell string 3. As shown in FIG. 8(a), in the case where the conductor wire 6 is provided in the plurality of places of the solar cell element 5, the second elastic member 74 is disposed corresponding to the positions in which the respective conductor wires 6 are located.

For the first elastic member 72 and the second elastic member 74, it is suitable to use a member having a rubber hardness of approximately 5 to 25. In this case, a bending stress is distributed and applied to the solar cell string 3. Furthermore, it is possible to use a material having an excellent abrasion resistance further suitably. As a specific material, for example, a foam product such as silicone rubber, fluororubber, or urethane rubber is suitable.

The rubber hardness can be measured in accordance with JIS-K6523.

In the second step using the processing apparatus 70 having such a structure, first of all, the solar cell string 3 is mounted on the base 71 in such a manner that the first main surface 5b is turned upward and the conductor wire 6 abuts on the first elastic member 72 as shown in FIG. 8(a). Then, the pressing roller 73 is moved downward by the moving means 75 in such a manner that the second elastic member 74 is positioned above the conductor wire 6. Thus, it is possible to implement a state in which the second elastic member 74 abuts on the solar cell string 3 and the solar cell string 3 is pressed by means of the pressing roller 73. With this pressing state maintained, when the moving means 75 is moved in an extending direction of the base 71 (an x-axis positive direction in FIG. 8(a)), that is, the array direction of the solar cell element 5 in the solar cell string 3 as shown in an arrow AR1 of FIG. 8(a), the pressing roller 73 is moved in the extending direction of the base 71 by rotating as shown in an arrow AR2 of FIG. 8(b), by a rotating force received from the solar cell string 3. Consequently, the solar cell string 3 is continuously pressed in the array direction of the solar cell element 5 by means of the pressing roller 73. In other words, there is implemented a state in which the pressing roller 73 continuously presses on the conductor wire 6 of the solar cell element 5 as seen on a plane.

In the state in which the pressing roller 73 carries out the pressing, the solar cell element 5 and the conductor wire 6 which constitute the solar cell string 3 are deformed so at to be is convexed toward the back surface 5a side as shown in FIG. 8(b).

More specifically, as shown in FIGS. 8(d) and 8(e), a pressing force applied from the pressing roller 73 mainly acts on a portion interposed between the first elastic member 72 and the second elastic member 74. In the case where a plurality of the conductor wires 6 are arranged in line as shown in FIG. 8(a), they are pressed individually and simultaneously. It is preferable that the first elastic member 72 and the second elastic member 74 which have greater widths than the width of the conductor wire 6 should be disposed so that the pressing by the pressing roller 73 be carried out around the conductor wire 6, and the total width of the conductor wire 6 is covered by the first elastic member 72. In this manner, the conductor wire 6 is pressed uniformly. For example, in the case where the conductor wire 6 has a width of approximately 2 mm, it is preferable to use the first elastic member 72 and the second elastic member 74 which have widths of approximately 10 mm.

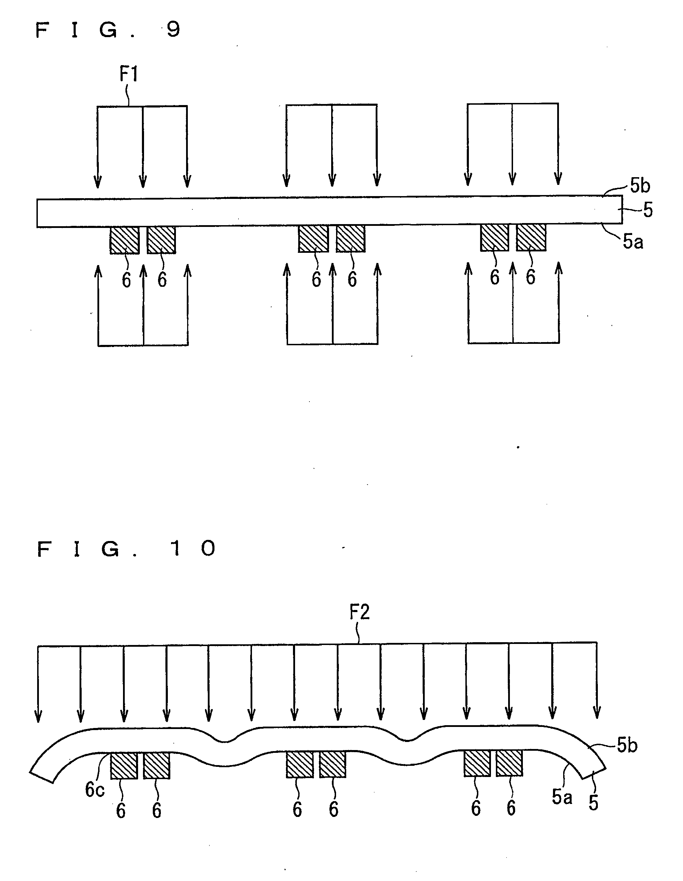

Moreover, in the second step, the pressing force from the pressing roller 73 is applied as a distributed load F1 to only the bonding portion of the conductor wire 6 and the solar cell element 5 and the vicinity thereof as shown in FIG. 9. As described above, a warpage occurring over the solar cell string 3 after the first step is mainly caused by the conductor wire 6 shrinking greater than the solar cell element 5. However, by sequentially applying the distributed load F1 in the longitudinal direction of the solar cell string 3, it is possible to extend the conductor wire 6 efficiently. As a result, it is possible to eliminate the warpage in the longitudinal direction of the conductor wire 6 which occurs over the solar cell string 3 after the first step.

Meanwhile, FIG. 10 shows, for comparison, a state in which a distributed load F2 is applied from the light receiving surface 5b side to the solar cell string 3 generally in the orthogonal direction to the longitudinal direction of the conductor wire 6. In this case, a difference occurs in quantity of flexure between the bonding portion of the solar cell element 5 and the conductor wire 6 and the other portions, and since the latter is flexed more greatly, the bending stress is maximized in a corner portion 6c of the conductor wire 6. Therefore, a crack is likely to occur with the corner portion 6c as a starting point.

On the other hand, in the present embodiment, a load is rarely applied to portions other than the bonding portion of the solar cell element 5 and the conductor wire 6 upon the pressing by the pressing roller 73, and the first elastic member 72 is deformed to cover the conductor wire 6 as shown in FIG. 8(e). Therefore, a stress concentration hardly occurs in the corner portion 6c of the conductor wire 6. In other words, in the present embodiment, the load to be applied to the solar cell element 5 in the second step is reduced and an unnecessary stress does not act on the solar cell string 3, whereby it is possible to reduce an occurrence of a crack in the solar cell element 5 or a separation of the conductor wire 6 from the solar cell element 5.

The solar cell string 3 is not directly pressed between the base 71 and the pressing roller 73 but is pressed through the first elastic member 72 and the second elastic member 74. It is advantageous in that the stress concentration on a part of the solar cell element 5 is reduced to distribute the stress.

More specifically, by pressing the solar cell string 3 through the first elastic member 72 and the second elastic member 74 as shown in FIG. 8(b), the first elastic member 72 and the second elastic member 74 are deformed upon the pressing. This increases a contact area of the first elastic member 72 and second elastic member 74 to the solar cell string 3 so that the bending stress is distributed and applied. Accordingly, it is possible to reduce the occurrence of the crack in the solar cell element 5.

Moreover, as shown in FIG. 8(c), also in the case where the conductor wire 6 has the concave portion 6a (the bonding portion) and the convex portion 6b (the non-bonding portion) as shown in FIG. 1, the solar cell element 5 and the conductor wire 6 are deformed in the same manner as in the case shown in FIG. 8(b). In this case, the first elastic member 72 and the second elastic member 74 are deformed along the concavo-convex portions of the conductor wire 6 when a pressing force is applied. Accordingly, in the same manner as in the case shown in FIG. 8(b), the bending stress is distributed and applied to the solar cell string 3, and as a result, it is possible to reduce the occurrence of the crack in the solar cell element 5.

As a result of the processing by using the processing apparatus 70, the solar cell string 3 has the shape shown in FIG. 3. In other words, a difference in a thermal strain between the solar cell element 5 and the conductor wire 6, which is generated after the solder bonding in the first step is subjected to leveling so that a thermal stress is reduced, whereby it is possible to obtain the solar cell string 3 in which the warpage in the longitudinal direction of the conductor wire 6 is reduced. The reason why the respective solar cell elements 5 in the solar cell string 3 shown in FIG. 3, has a convex shape toward the light receiving surface 5b side in the perpendicular section to the longitudinal direction of the conductor wire 6 is because the conductor wire 6 is extended in the second step as described above so that the heat shrinkage of the solar cell element 5 which has been relatively smaller than the heat shrinkage of the conductor wire 6 is made remarkable.

Further, in the solar cell module, it is preferable that at least one of the at least one first conductor wire and the at least one second conductor wire have a connecting portion to be connected to the back surface of the solar cell element and a non-connecting portion which is not connected thereto, and an angle between the connecting portion and the non-connecting portion should be greater than 90 degrees.

Consequently, the conductor wire 6 is likely to be deformed along the concavo-convex portions.

In addition, it is preferable that the solar cell module have the plurality of conductor wires formed by a clad copper foil.

Consequently, it is also possible to cause a coefficient of thermal expansion of a core member in the conductor wire 6 to approximate to that of ceramic. Thus, it is possible to reduce a warpage.

Moreover, in the solar cell module, it is preferable that the solar cell element have a rectangular shape and the plurality of conductor wires be parallel with one of the sides of the solar cell element.

Consequently, it is possible to wholly cause a warpage in a certain direction.

Further, in the solar cell module, it is preferable that the at least one first conductor wire and the at least one second conductor wire be positioned alternately.

Consequently, it is possible to wholly cause a warpage in a certain direction.

In addition, the solar cell module can also be applied to the case in which, among the plurality of solar cell elements, two adjacent solar cell elements are connected electrically at the light receiving surface of one solar cell element and at the other back surface of the other solar cell element through each of the plurality of conductor wires.

Then, the solar cell string 3 is subjected to the step of laminating the translucent substrate 1, the light receiving surface side filler 2a, the non-light receiving surface side filler 2b, and the back surface protecting member 4 and heating, and pressurizing the laminated body thus obtained, thereby melting the filler 2. Thus, the solar cell module X which is wholly integrated as shown in FIG. 1 or 4 is obtained. In other words, it is possible to realize the solar cell module X in which the thermal stress to be applied to the solder in the bonding portion of the solar cell element 5 and the conductor wire 6 is suitably reduced and the creep deformation of the solder or the corresponding occurrence of the separation in the bonding portion is reduced. In the case where the solar cell string 3 has the shape shown in FIG. 3, there is also an advantage that the alignment precision in the longitudinal direction of the solar cell string 3 upon laminating as above is enhanced.

On the other hand, if the solar cell string 3a is laminated as is on the filler 2 and the other members, four corner portions of the solar cell element 5 may be caught on the filler 2 and a load is likely to be generated in the corner portions. As a result, the occurrence of the crack in the solar cell element 3 or the bend of the conductor wire 6 is likely to be caused upon the heating and pressurization of the filler 2, which is not preferable.

Moreover, even if the conductor wire 6 is extended to planarize the solar cell string 3a in the array direction of the solar cell element 5 upon the heating and pressurization for the integration, the solar cell string 3 is hardly extended evenly and flatly and the crack is likely to occur in the solar cell element 5, which is not preferable. This is because the solar cell elements 5 are connected to each other through the conductor wire 6, while the solar cell element 5 is curved in the longitudinal direction of the conductor wire 6.

As compared with this, referring to the manufacturing method according to the present embodiment, the solar cell string 3 planarized in the longitudinal direction of the conductor wire 6 in advance through the second step is used to constitute the solar cell module X. Preferably, the solar cell module X is constituted by using the solar cell string 3 including the solar cell element 5 having a convex shape toward the light receiving surface 5b side and having the first maximum distance d1 which is greater than the second maximum distance d2. Thus, it is possible to suitably reduce the occurrence of the crack or the like in such a manufacturing process.

### <Method of Verifying Shape of Solar Cell Element in Solar Cell Module>

It is possible to verify, by disassembling an actual product, that each of the solar cell elements 5 in the solar cell string 3 has a protruded shape toward the light receiving surface 5b side in the longitudinal direction of the conductor wire 6 in the solar cell module X according to the embodiment of the present invention. For example, it is possible to carry out the verification by dissolving the filler 2 of the solar cell module X to take out the solar cell string 3 by the following method.

First of all, the back surface protecting member 4 is cut in. The cut-in processing may be carried out by a manual work using a cutter, a disc type cutter, a laser cutter, or the like, but more preferably carried out by using an automatic machine of a disc type cutter, a disc type grindstone, or a laser cutter. Accordingly, it is possible to quicken a penetration of an organic solvent, thereby shortening a time required for collecting the solar cell string 3.

Then, a vessel having such a size that the whole solar cell module X can be put in at least a horizontal condition is filled with the organic solvent for decomposing the filler 2, and furthermore, the solar cell module X is immersed in the vessel. For the organic solvent, it is possible to use d-limonene, xylene, toluene, or the like. The organic solvent may be maintained at an ordinary temperature, however, by raising the temperature to 80°C to 100°C, it is possible to quicken the dissolution of the filler 2, thereby shortening a time required for the decomposition. By immersing the solar cell module X for approximately 24 hours if the organic solvent is maintained at the ordinary temperature, and immersing for approximately one to two hours if the organic solvent is heated to 80°C to 100°C, the filler 2 is dissolved, and thus, the solar cell string 3 can be taken out.

The shape of the solar cell string 3 thus taken out can be measured by an apparatus for measuring a shape of a three-dimensional curved surface by means of a laser, for example. In addition, it is also possible to measure the shape by putting the solar cell string 3 on a platen, and measuring a lift from the platen by means of a caliper and carrying out plotting. By these techniques, the shape of the solar cell string 3 is specified and the solar cell element 5 is confirmed to have the wavy shape shown in the embodiment described above.

Alternatively, it is also possible to specify the warpage shapes of the solar cell element 5 and the solar cell string 3 by focusing observed light in a plurality of places of the light receiving surface 5b in the solar cell element 5 from an outside of the solar cell module X, measuring a focal depth in the respective places, and plotting a spatial change thereof by means of an optical observing device such as an optical microscope.

## Claims

1. A solar cell module comprising (X; Xa):
a plurality of solar cell elements (5), each including a light receiving surface (5b) and a back surface (5a) positioned on a back side of said light receiving surface; and
a plurality of conductor wires (6), each connecting one of the solar cell elements to any of the solar cell elements which is adjacent thereto and including connecting portions to be connected to one surface of one of the solar cell elements, wherein
said plurality of solar cell elements have a convex shape toward said light receiving surface side in the perpendicular section to the longitudinal direction of said connecting portions, and **characterised in that** the
rate d1/d2 is 1.5 to 20, d1 being the maximum distance in the thickness direction from said light receiving surface to said back surface in the perpendicular section to the longitudinal direction of said connecting portion and d2 being the maximum distance in said thickness direction in a section in the longitudinal direction of said connecting portion.

2. The solar cell module according to claim 1, wherein said distance d2 is equal to or smaller than 20 times as much as the thickness of said solar cell element.

3. The solar cell module according to claim 1 or 2, wherein said distance d1 is equal to 21 to 40 times as much as the thickness of said solar cell element.

4. The solar cell module according to any of claims 1 to 3, wherein said plurality of conductor wires include at least one first conductor wire (61) and at least one second conductor wire (62) having an opposite polarity to said at least one first conductor wire with respect to each of said solar cell elements.

5. The solar cell module according to claim 4, wherein said at least one first conductor wire and said at least one second conductor wire are parallel with each other.

6. The solar cell module according to any of claims 1 to 5, wherein said plurality of conductor wires, each includes the connecting portion to be connected to the back surface of the solar cell element and a non-connecting portion which is not connected to the back surface of the solar cell element, and the connecting portion and the non-connecting portion are arranged alternately.

7. The solar cell module according to any of claims 4 to 6, wherein at least one of said at least one first conductor wire and said at least one second conductor wire includes the connecting portion to be connected to said back surface of each of said solar cell elements and a non-connecting portion which is not connected to said back surface of each of said solar cell elements, and the angle between said connecting portion and said non-connecting portion is greater than 90 degrees.

8. The solar cell module according to any of claims 4 to 7, wherein said at least one first conductor wire and said at least one second conductor wire are positioned alternately.

9. The solar cell module according to any of claims 1 to 8, wherein adjacent two solar cell elements among said plurality of solar cell elements are electrically connected at said back surface of one solar cell element and at said back surface of the other solar cell element through said plurality of conductor wires.

10. A method of manufacturing a solar cell module comprising (X; Xa):
a first step of electrically connecting, through a conductor wire (6) comprising a connecting portion, adjacent two solar cell elements (5) among a plurality of solar cell elements each including a light receiving surface (5b) and a back surface (5a) positioned on the back side of said light receiving surface; and
a second step of supporting said plurality of connected solar cell elements to be connected with a support member (71, 72) from a back surface side of said plurality of connected solar cell elements and continuously pressing in a longitudinal direction of said conductor wire by a pressing member from a light receiving surface side of said solar cell element,
wherein the rate d1/d2 is 1.5 to 20, d1 being the maximum distance in the thickness direction from said light receiving surface to said back surface in the perpendicular section to the longitudinal direction of said connecting portion and d2 being the maximum distance in said thickness direction in a section in the longitudinal direction of said connecting portion.

11. The method of manufacturing a solar cell module according to claim 10, wherein said pressing member continuously presses on said conductor wire of said solar cell element.

12. The method of manufacturing a solar cell module according to claim 10 or 11, wherein a width of said pressing member is greater than the width of said conductor wire.

13. The method of manufacturing a solar cell module according to any of claims 10 to 12, wherein
said conductor wire has a convex portion and a concave portion alternately in the longitudinal direction, and
said concave portion is bonded to said back surfaces of said plurality of solar cell elements in said first step.

## Patentansprüche

1. Solarzellenmodul (X; Xa) mit:
einer Vielzahl an Solarzellenelementen (5), die jeweils eine Lichtempfangsfläche (5b) und eine auf einer Rückseite der Lichtempfangsfläche angeordnete Rückfläche (5a) aufweisen; und
eine Vielzahl an Leitungsdrähten (6), die jeweils eines der Solarzellenelemente mit einem der dazu benachbarken Solarzellenelemente verbinden und die Verbindungsabschnitte aufweisen, die mit einer Fläche eines der Solarzellenelemente zu verbinden sind,
wobei die Vielzahl an Solarzellenelementen eine konvexe Form in Richtung der Lichtempfangsflächenseite in dem Abschnitt senkrecht zu der Längsrichtung der Verbindungsabschnitte aufweist, und **dadurch gekennzeichnet, dass**
das Verhältnis d1/d2 1,5 bis 20 beträgt, wobei d1 der maximale Abstand in der Dickenrichtung von der Lichtempfangsfläche zu der Rückfläche in dem Abschnitt senkrecht zu der Längsrichtung des Verbindungsabschnitts ist und wobei d2 der maximale Abstand in der Dickenrichtung in einem Abschnitt in der Längsrichtung des Verbindungsabschnitts ist.

2. Solarzellenmodul gemäß Anspruch 1, wobei der Abstand d2 gleich oder kleiner als das 20-fache der Dicke des Solarzellenelements beträgt.

3. Solarzellenmodul gemäß Anspruch 1 oder 2, wobei der Abstand d1 gleich dem 21-bis 40-fachen der Dicke des Solarzellenelements beträgt.

4. Solarzellenmodul gemäß einem der Ansprüche 1 bis 3, wobei die Vielzahl an Leitungsdrähten wenigstens einen ersten Leitungsdraht (61) und wenigstens einen zweiten Leitungsdraht (62), der gegenüber dem wenigstens ersten Leitungsdraht mit Bezug auf jedes der Solarzellenelemente eine umgekehrte Polarität aufweist, umfasst.

5. Solarzellenmodul gemäß Anspruch 4, wobei der wenigstens erste Leitungsdraht und der wenigstens zweite Leitungsdraht parallel zueinander sind.

6. Solarzellenmodul gemäß einem der Ansprüche 1 bis 5, wobei die Vielzahl an Leitungsdrähten jeweils den Verbindungsabschnitt, der mit der Rückfläche des Solarzellenelements zu verbinden ist, und einen Nicht-Verbindungsabschnitt, der nicht mit der Rückfläche des Solarzellenelements verbunden ist, aufweist und wobei der Verbindungsabschnitt und der Nicht-Verbindungsabschnitt abwechselnd angeordnet sind.

7. Solarzellenmodul gemäß einem der Ansprüche 4 bis 6, wobei wenigstens einer des wenigstens einen ersten Leitungsdrahts und des wenigstens einen zweiten Leitungsdrahts den mit der Rückfläche jedes der Solarzellenelemente zu verbindenden Verbindungsabschnitt und einen Nicht-Verbindungsabschnitt, der nicht mit der Rückfläche jedes der Solarzellenelemente verbunden ist, aufweist, und wobei der Winkel zwischen dem Verbindungsabschnitt und dem Nicht-Verbindungsabschnitt größer als 90 Grad ist.

8. Solarzellenmodul gemäß einem der Ansprüche 4 bis 7, wobei der wenigstens eine erste Verbindungsdraht und der wenigstens eine zweite Verbindungsdraht abwechselnd angeordnet sind.

9. Solarzellenmodul gemäß einem der Ansprüche 1 bis 8, wobei zwei benachbarte Solarzellenelemente aus der Vielzahl an Solarzellenelementen elektrisch an der Rückfläche eines Solarzellenelements und an der Rückfläche des anderen Solarzellenelements durch die Vielzahl an Leitungsdrähten elektrisch verbunden sind.

10. Verfahren zur Herstellung eines Solarzellenmoduls (X; Xa) mit:
einem ersten Schritt des elektrischen Verbindens, durch einen Leitungsdraht (6) mit einem Verbindungsabschnitt, zweier benachbarter Solarzellenelemente (5) aus einer Vielzahl an Solarzellenelementen, die jeweils eine Lichtempfangsfläche (5b) und eine auf der Rückseite der Lichtempfangsfläche angeordnete Rückfläche (5a) aufweisen; und
einem zweiten Schritt des Abstützens der Vielzahl an verbundenen Solarzellenelementen, die zu verbinden sind, mit einem Abstützteil (71, 72) von einer Rückflächenseite der Vielzahl an verbundenen Solarzellenelementen und des kontinuierlichen Drückens in einer Längsrichtung des Leitungsdrahtes durch ein Druckteil von einer Lichtempfangsflächenseite des Solarzellenelements aus,
wobei das Verhältnis d1/d2 1,5 bis 20 beträgt, wobei d1 der maximale Abstand in der Dickenrichtung von der Lichtempfangsfläche zu der Rückfläche in dem Abschnitt senkrecht zu der Längsrichtung des Verbindungsabschnitts ist und wobei d2 der maximale Abstand in der Dickenrichtung in einem Abschnitt in der Längsrichtung des Verbindungsabschnitts ist.

11. Verfahren zur Herstellung eines Solarzellenmoduls gemäß Anspruch 10, wobei das Druckteil kontinuierlich auf den Leitungsdraht des Solarzellenelements drückt.

12. Verfahren zur Herstellung eines Solarzellenmoduls gemäß Anspruch 10 oder 11, wobei eine Breite des Druckteils größer ist als die Breite des Leitungsdrahts.

13. Verfahren zur Herstellung eines Solarzellenmoduls gemäß einem der Ansprüche 10 bis 12, wobei
der Leitungsdraht einen konvexen Abschnitt und einen konkaven Abschnitt abwechselnd in der Längsrichtung aufweist, und
der konkave Abschnitt mit den Rückflächen der Vielzahl an Solarzellenelementen in dem ersten Schritt verbunden wird.

## Revendications

1. Module de cellules solaires (X ; Xa) comprenant :
une pluralité de cellules solaires élémentaires (5), chacune comportant une surface recevant la lumière (5b) et une surface arrière (5a) positionnée sur le côté arrière de ladite surface recevant la lumière ; et
une pluralité de fils conducteurs (6), chacun reliant une des cellules solaires élémentaires à n'importe quelle cellule solaire élémentaire qui lui est adjacente et comportant des parties de connexion à relier à une surface d'une des cellules solaires élémentaires, dans lequel
ladite pluralité de cellules solaires élémentaires a une forme convexe vers le côté de ladite surface recevant la lumière dans la section perpendiculaire à la direction longitudinale desdites parties de connexion, et **caractérisé en ce que**
le rapport d1/d2 est de 1,5 à 20, d1 étant la distance maximale dans la direction de l'épaisseur de ladite surface recevant la lumière à ladite surface arrière dans une coupe perpendiculaire à la direction longitudinale de ladite partie de connexion et d2 étant la distance maximale dans ladite direction de l'épaisseur dans une coupe dans la direction longitudinale de ladite partie de connexion.

2. Module de cellules solaires selon la revendication 1, dans lequel ladite distance d2 est égale ou inférieure à 20 fois l'épaisseur de ladite cellule solaire élémentaire.

3. Module de cellules solaires selon la revendication 1 ou 2, dans lequel ladite distance d1 est égale à 21 à 40 fois l'épaisseur de ladite cellule solaire élémentaire.

4. Module de cellules solaires selon l'une quelconque des revendications 1 à 3, dans lequel ladite pluralité de fils conducteurs comporte au moins un premier fil conducteur (61) et au moins un deuxième fil conducteur (62) ayant une polarité opposée audit au moins un premier fil conducteur par rapport à chacune desdites cellules solaires élémentaires.

5. Module de cellules solaires selon la revendication 4, dans lequel ledit au moins un premier fil conducteur et ledit au moins un deuxième fil conducteur sont parallèles l'un à l'autre.

6. Module de cellules solaires selon l'une quelconque des revendications 1 à 5, dans lequel dans ladite pluralité de fils conducteurs, chacun comporte la partie de connexion à relier à la surface arrière de la cellule solaire élémentaire et une partie de non-connexion qui n'est pas reliée à la surface arrière de la cellule solaire élémentaire, et la partie de connexion et la partie de non-connexion sont disposées en alternance.

7. Module de cellules solaires selon l'une quelconque des revendications 4 à 6, dans lequel ledit au moins un premier fil conducteur et/ou ledit au moins un deuxième fil conducteur comportent la partie de connexion à relier à ladite surface arrière de chacune desdites cellules solaires élémentaires et une partie de non-connexion qui n'est pas reliée à ladite surface arrière de chacune desdites cellules solaires élémentaires, et l'angle entre ladite partie de connexion et ladite partie de non-connexion est supérieur à 90 degrés.

8. Module de cellules solaires selon l'une quelconque des revendications 4 à 7, dans lequel ledit au moins un premier fil conducteur et ledit au moins un deuxième fil conducteur sont positionnés en alternance.

9. Module de cellules solaires selon l'une quelconque des revendications 1 à 8, dans lequel deux cellules solaires élémentaires adjacentes parmi ladite pluralité de cellules solaires élémentaires sont reliées électriquement à ladite surface arrière d'une cellule solaire élémentaire et à ladite surface arrière de l'autre cellule solaire élémentaire par ladite pluralité de fils conducteurs.

10. Procédé de fabrication d'un module de cellules solaires (X ; Xa) comprenant :
une première étape consistant à relier électriquement, par un fil conducteur (6) comprenant une partie de connexion, deux cellules solaires élémentaires adjacentes (5) parmi une pluralité de cellules solaires élémentaires comportant chacune une surface recevant la lumière (5b) et une surface arrière (5a) positionnée sur le côté arrière de ladite surface recevant la lumière ; et
une deuxième étape consistant à soutenir ladite pluralité de cellules solaires élémentaires reliées à relier avec un élément de support (71, 72) depuis le côté de la surface arrière de ladite pluralité de cellules solaires élémentaires reliées et appuyer en continu dans une direction longitudinale dudit fil conducteur avec un élément de pression depuis le côté de la surface recevant la lumière de ladite cellule solaire élémentaire,
dans lequel le rapport d1/d2 est de 1,5 à 20, d1 étant la distance maximale dans la direction de l'épaisseur de ladite surface recevant la lumière à ladite surface arrière dans une coupe perpendiculaire à la direction longitudinale de ladite partie de connexion et d2 étant la distance maximale dans ladite direction de l'épaisseur dans une coupe dans la direction longitudinale de ladite partie de connexion.

11. Procédé de fabrication d'un module de cellules solaires selon la revendication 10, dans lequel ledit élément de pression appuie en continu sur ledit fil conducteur de ladite cellule solaire élémentaire.

12. Procédé de fabrication d'un module de cellules solaires selon la revendication 10 ou 11, dans lequel une largeur dudit élément de pression est supérieure à la largeur dudit fil conducteur.

13. Procédé de fabrication d'un module de cellules solaires selon l'une quelconque des revendications 10 à 12, dans lequel
ledit fil conducteur a une partie convexe et une partie concave en alternance dans la direction longitudinale, et
ladite partie concave est collée auxdites surfaces arrière de ladite pluralité de cellules solaires élémentaires dans ladite première étape.
